Europäisches Patentamt

European Patent Office

Office européen des brevets

(19)

(11) Veröffentlichungsnummer: **0 182 140 B1**

(12) # EUROPÄISCHE PATENTSCHRIFT

(45) Veröffentlichungstag der Patentschrift:
**17.05.89**

(21) Anmeldenummer: **85113466.8**

(22) Anmeldetag: **23.10.85**

(51) Int. Cl.⁴: **H01L 25/16, H01L 41/08**

(54) **Ultraschall-Detektionssensor in Hybridaufbau mit zugehöriger Elektronikschaltung.**

(30) Priorität: **25.10.84 DE 3439168**

(43) Veröffentlichungstag der Anmeldung:
**28.05.86 Patentblatt 86/22**

(45) Bekanntmachung des Hinweises auf die Patenterteilung:
**17.05.89 Patentblatt 89/20**

(84) Benannte Vertragsstaaten:
**DE FR GB IT SE**

(56) Entgegenhaltungen:
**DE-A- 2 433 389**
**DE-A- 2 537 788**
**DE-A- 3 241 033**
**US-A- 3 453 711**

(73) Patentinhaber: **Siemens Aktiengesellschaft Berlin und München, Wittelsbacherplatz 2, D-8000 München 2(DE)**

(72) Erfinder: **Mágori, Valentin, Dipl.-Phys., Limburgstrasse 17, D-8000 München 90(DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die vorliegende Erfindung bezieht sich auf einen Ultraschall-Detektionssensor, wie im Oberbegriff des Patentanspruchs 1 angegeben.

Es ist bekannt, mit Ultraschall zwischen Körpern vorhandene Abstände zu detektieren. Im Regelfall ist dabei ein Ultraschall-Wandler an dem einen Körper angebracht und es wird die Laufzeit der an dem im Abstand gegenüberstehenden Körper reflektierten und empfangenen Ultraschall-Strahlung ausgewertet. Sendewandler und Empfangswandler können auch voneinander getrennt am jeweils einander gegenüberstehenden Körper angebracht sein, jedoch erfordert dies zwei getrennte Wandler. Der eine oder die beiden Körper können auch sonstige Ultraschall reflektierende Grenzflächen, wie z.B. eine Flüssigkeitsoberfläche, sein. Letzteres wird bei Flüssigkeitsstands-Detektoren mit Ultraschall ausgenutzt, wobei an der Flüssigkeitsoberfläche entweder in die Flüssigkeit zurückreflektierte oder außen an der Flüssigkeitsoberfläche zurückreflektierte Ultraschall-Strahlung ausgewertet wird. Bekannt sind z.B. Tankmeßgeräte, insbesonder für Treibstofftanks in Kraftfahrzeugen. Zu einem solchen Gerät gehört ein beispielsweise am Boden des Kraftstofftanks angebrachter Ultraschall-Wandler, dessen ausgesandte Ultraschall-Strahlung an der Oberfläche des im Tank befindlichen Treibstoffes reflektiert wird und in den Empfangswandler (der auch Sendewandler sein kann) zurückgelangt. Auch die Auswertung einer solchen Betriebsweise ist bekannt.

Insbesondere für die Anwendung in großen Stückzahlen, wie z.B. bei Kraftfahrzeugserien, ist es erforderlich, Wandler zur Verfügung zu haben, die sowohl leistungsfähig sind als auch einfachen und insbesondere robusten Aufbau (preisgünstige Ausführung) haben. Es ist Aufgabe der vorliegenden Erfindung, ein derartiges Bauelement anzugeben.

Diese Aufgabe ist mit einem Ultraschall-Sensor mit den Merkmalen des Patentanspruchs 1 gelöst. Weitere Ausgestaltungen und Weiterbildungen der Erfindung gehen aus den Unteransprüchen hervor.

Der Erfindung liegen mehrere Einzelgedanken zugrunde, und zwar insbesondere der, einen solchen Aufbau des Ultraschall-Wandlers zu finden, der möglichst gute akustische Widerstandsanpassung besitzt. Bei der Erfindung ist die Möglichkeit genutzt, mittels Kunststoffmaterial auf einfachem Wege akustische Widerstandsanpassung zu erreichen. Weiterhin liegt der Erfindung der Gedanke zugrunde, einen möglichst kompakten Aufbau zu haben, der nicht nur integriertes Herstellungsverfahren ermöglicht, sondern der auch Aufwand beim Einbau des Gerätes beim Anwender einspart. Bei der Erfindung ist ein Substratmaterial vorgesehen, das eine harte akustische Masse als 'backing' bildet. Der eigentliche Ultraschall-Wandler besteht aus einer Scheibe aus Piezo-Keramik und daran vorder- und rückseitig angebrachten Kunststoffkörpern. Dieser Verbund bildet einen Viertelwellenlängen-Wandler ($\lambda/4$ bzw. $(2n+1) \cdot \lambda/4$-Wandler). Mit der einen Fläche ist dieser Verbundwandler - im folgenden kurz Wandler genannt - an dem Substrat angebracht. Die andere Fläche des Wandlers ist die Abstrahlfläche, an die das Schallausbreitungs-Medium, vorzugsweise Flüssigkeit, angrenzt. Bei der Erfindung ist vorgesehen, möglichst weitgehend akustische Anpassung zu erreichen. Möglichst weitgehend wird angestrebt, daß der Mittelwert des Produkts aus Schallgeschwindigkeit und Dichte beim Wandler zwischen den entsprechenden Produktwerten des Substratmaterials einerseits und angrenzender Flüssigkeit andererseits liegt. Durch den geschichteten Aufbau des Wandlers aus Piezokeramikfolie und aus Kunststoff- oder Piezopolymerfolie läßt sich für den Wandler ein solcher Mittelwert erreichen.

Auf einem wie erwähnten Substrat kann ein einzelner Ultraschall-Wandler aufgebracht sein. Es können auch zwei Wandler aufgebracht sein, von denen der eine Wandler als Sendewandler und der andere als Empfangswandler verwendet wird. Die Erfindung umfaßt aber auch Ultraschall-Array-Anordnungen, die aus mehreren funktionell getrennt auf ein und demselben Substrat angebrachten Wandlern bestehen, die nach jeweils bekanntem Muster als Sendewandler-Array angeregt werden.

Bei der Erfindung ist als weitergehende Maßnahme vorgesehen, auf dem Substrat auch die elektronische Auswerteschaltung anzuordnen. In einem solchen Fall bedarf diese Anordnung nur noch der Zuführung der Versorgungsspannung und sie besitzt einen Signalausgang, der direkt an eine endgültige Anzeige (Tankuhr im Armaturenbrett) geführt werden kann. Die elektrischen Verbindungen auf dem Substrat sind vorzugsweise als Leiterbahnen ausgeführt. Vorzugsweise ist die kurze Verbindung zur Elektrode am schwingenden Wandler ein Draht bzw. eine Litze. Bevorzugtes Substratmaterial ist solches, das auch für Dickschichtschaltungen verwendet wird.

Weitere Erläuterungen der Erfindung gehen aus der nachfolgenden, anhand der Figuren gegebenen Beschreibung hervor.

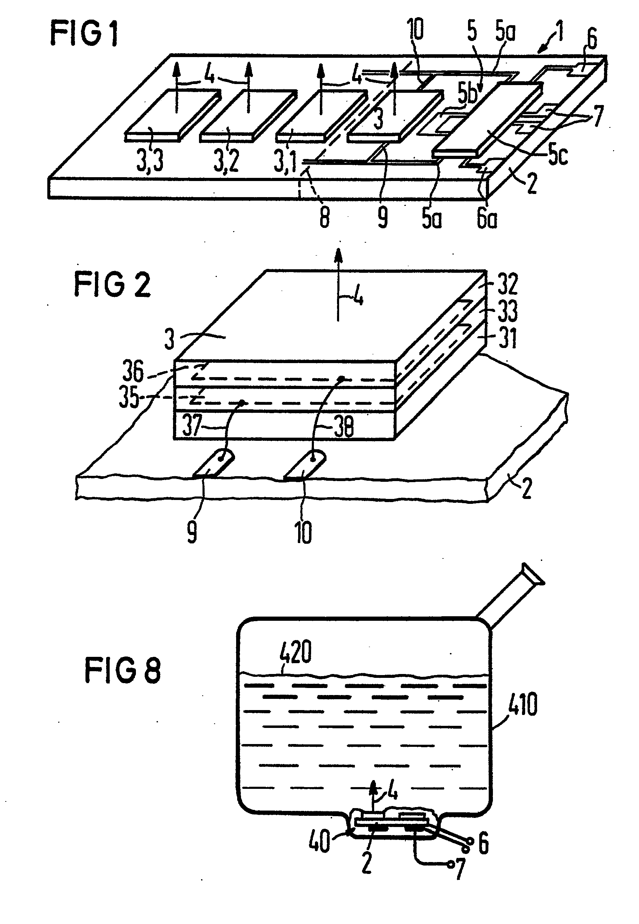

In Fig.1 ist mit 1 eine Wandler-Anordnung bezeichnet. Auf einer Substratplatte 2 aus beispielsweise gesintertem Aluminiumoxid oder Keramik sind beispielsweise vier Ultraschall-Wandler 3; 3,1; 3,2; 3,3 in vorzugsweise einer Reihe angeordnet. Mit 4 ist auf die Hauptausstrahlrichtung des einzelnen Wandlers 3 bzw. der Array-Anordnung mit den Wandlern 3 bis 3,3 (bei phasengleicher Anregung) hingewiesen.

Mit 5 ist eine auf der Substratplatte angeordnete Elektronikschaltung bezeichnet, die eine Dick-Schichtschaltung mit Leiterbahnen 5a, Dickschicht-Bauelementen 5b und mit gegebenenfalls in Hybridtechnik zusätzlich aufgesetzten Bauelementen 5c ist. An die Anschlüsse 6, 6a ist die elektrische Versorgungsspannung U anzuschließen; der Anschluß 7 ist der ein- oder zweipolige Signalausgang. Die Elektronikschaltung 5 ist insbesondere so ausgebildet, daß man mit ihr sowohl die Sende-Anregung der Wandler als auch die Auswertung der den Wandlern zu entnehmenden Empfangssignale durchführen kann.

Die gestrichelte Linie 8 gibt eine in Fig.1 linksseitige Begrenzung eines beispielsweise als Tanksensor zu verwendenden Ultraschall-Abstandssensors an. Am Ort der Linie 8 abgetrennt besteht der in Fig.1 rechtsseitig verbleibende Anteil aus dem einen (als Sendewandler und als Empfangswandler zu verwendenden) Ultraschall-Wandler 3 und der Elektronik 5. Dieser Ultraschall-Wandler 3 und die Elektronik 5 befinden sich als Hybridaufbau auf dem gemeinsamen Substrat 2. Mit 9, 10 ist auf Verbindungsleitungen zwischen dem Wandler 3 und der Elektronik 5 hingewiesen.

Die Wandler 3; 3,1 ... sind auf der einen und die Elektronikschaltung ist auf derselben und/oder der anderen Oberflächenseite der Substratplatte 2 angeordnet.

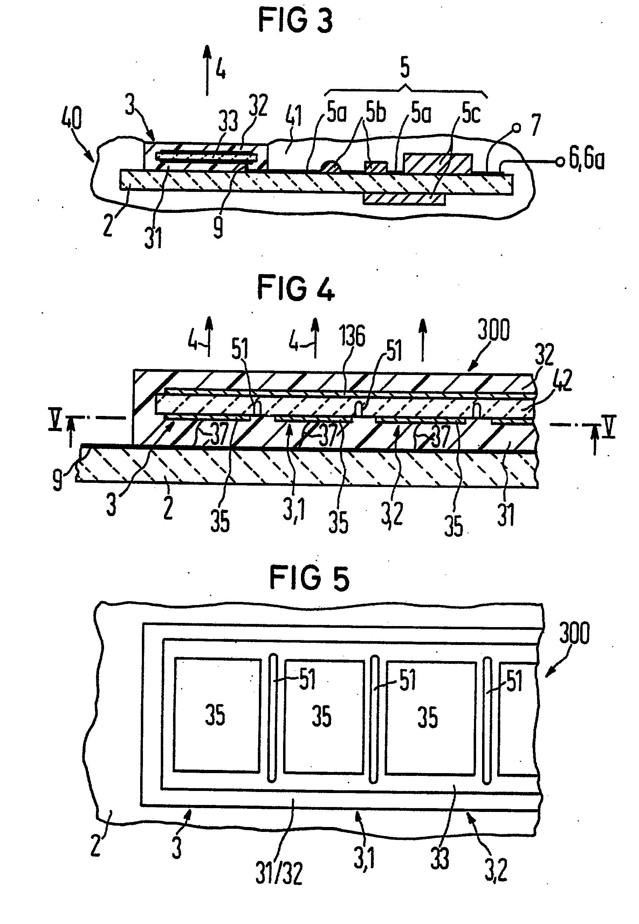

Fig.2 gibt in erheblich vergrößerter Darstellung einen bei der Erfindung verwendeten Schichtaufbau für den Wandler 3 wieder. Der Wandler 3 besteht aus der Piezokeramikfolie 33 und den anliegenden Folien 31 und 32 aus einem Material mit einer spezifischen Dichte kleiner als etwa 2, das insbesondere ein (Kohlenstoff- und/oder Silizium-)Polymer-Kunststoff sein kann. Als Kunststoffe eignen sich beispielsweise Polymeräthylen, Epoxid, PVDF u.s.w.. Vorzugsweise umhüllt der Kunststoff die Keramik auch seitlich (Fig. 3, 6,7).

Auf den Oberflächen besitzt die Keramikfolie 33 an sich bekannte Elektrodenbelegungen 35, 36. Mit 37 ist ein erster und mit 38 ist ein zweiter, an der Außenseite der Folie 33 elektrisch isoliert geführter Anschluß für den Wandler 3 bezeichnet. Diese Anschlüsse 37 und 38 sind mit den Leiterbahnen 9 und 10 und damit mit der Elektronikschaltung 5 verbunden.

Die Substratplatte 2 kann an der Stelle, wo die Wandler 3; 3,1; ... aufgebracht sind, zum Zweck der elektrischen Schirmung und zur Verbesserung der Klebfähigkeit mit einer elektrisch leitfähigen Schicht, z.B. aus Einbrennmetall oder aus aufgesputtertem Metall, belegt sein.

Figur 3 gibt eine seitliche Schnittansicht eines Sensors 40, wie der in Figur 1 von der Linie 8 rechtsseitige Anteil, hier in Figur 3 jedoch mit allseitiger Schutzumhüllung 41, wieder. Die Schutzumhüllung ist z.B. ein Tauchlack oder eine durch Wirbelsintern aufgebrachte Umhüllung. Wie ersichtlich, ist die für die Schallabstrahlung 4 vorgesehene Oberfläche des Wandlers 3 freigehalten. Diese Oberfläche des Wandlers 3 besteht ohnehin aus dem Kunststoffmaterial der Folie 32. Die Anschlüsse 6, 6a und 7 sind durch die Umhüllung 41 hindurch herausgeführt und stehen zu ihrer jeweiligen Verwendung zur Verfügung. Die übrigen Bezugszeichen in Figur 3 beziehen sich auf zu den Figuren 1 und 2 beschriebene Einzelheiten.

Eine Anordnung nach Figur 3 ist vielseitig verwendbar und kann z.B. auch im Inneren von Flüssigkeitsbehältern, und zwar auch untergetaucht, in der Flüssigkeit benutzt und betrieben werden. Dies kann auch im Zusammenhang mit aggressiven und/oder Lösungsmittelcharakter aufweisenden Flüssigkeiten erfolgen, da für die Schutzumhüllung jeweils geeignete Materialien bekanntermaßen zur Verfügung stehen.

Figur 4 zeigt als Ausschnitt skizzenhaft eine Ausführungsform eines Wandler-Arrays für eine Anordnung nach der vorliegenden Erfindung. Die Schnittdarstellung zeigt denjenigen Anteil der Substratplatte 2, auf dem sich das Wandler-Array 3; 3,1; 3,2 ... befindet. Mit 31 und 32 sind die Kunststoff-Folien bezeichnet, die eine beispielsweise streifenförmige Piezokeramikfolie 42 wie dargestellt umhüllen. Die Wandler 3; 3,1; 3,2 ... sind hier integrale Bestandteile des gesamten Wandler-Arrays 300. Mit 35 ist die jeweils eine Elektrodenbelegung des Wandlers 3, des Wandlers 3, 1, des Wandlers 3, 2 usw. bezeichnet. Die gegenüberliegende Elektrodenbelegung 136 kann eine durchgehende streifenförmige Belegung sein, durch die die Wandler 3; 3,1; 3,2 ... miteinander einpolig verbunden sind. Durch entsprechende Anregung über die Anschlüsse 37 können die einzelnen Wandler 3; 3,1; 3,2 ... der vorgegebenen Betriebsweise des Arrays entsprechend, beispielsweise gleichphasig oder mit verschiedener Phase, zu Ultraschallschwingungen angeregt werden. Figur 5 zeigt ebenfalls lediglich skizzenhaft in Aufsicht den Schnitt V, Va aus Fig. 4, und zwar in Höhe der Unterseite des Piezokeramikstreifens 42. Durch Einschnitte 51 in den Piezokeramikstreifen 42 sind die einzelnen Wandler 3; 3, 1; 3, 2 ... hinsichtlich ihrer Funktion als Ultraschallschwinger voneinander entkoppelt.

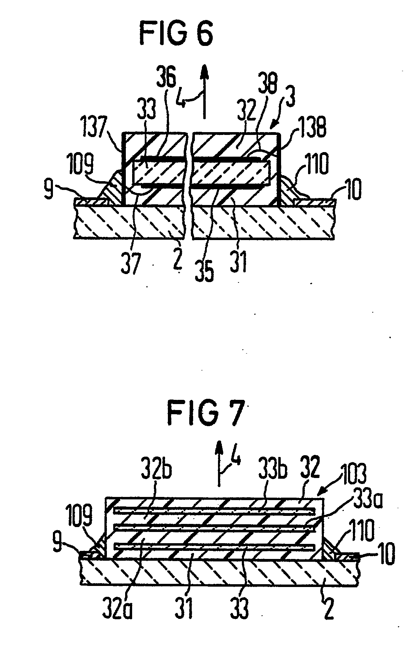

Figur 6 zeigt ein spezielles Beispiel für die Ausführung der Kontaktierung der Elektrodenbelegungen 35 und 36 der Piezokeramikfolie 33 eines Wandlers 3. Wieder ist mit 2 der entsprechende Ausschnitt der Substratplatte bezeichnet. Mit 33 ist die Piezokeramikfolie mit ihren Elektrodenbelegungen 35 und 36 bezeichnet. Die Anschlußleitungen 37 und 38 sind feine Drähte oder Litzen, die zu stirnseitigen Metallisierungen 137 und 138 des Wandlers 3 bzw. seiner Kunststoff-Folien 31 und 32 führen. Mit 9 und 10 sind wiederum die auf der Substratplatte 2 aufgebrachten, für den Anschluß des Wandlers 3 vorgesehenen Leiterbahnen bezeichnet. Mit 109 und 110 sind Lotverbindungen zwischen der Leiterbahn 9 und der Metallisierung 137 bzw. der Leiterbahn 10 und der Metallisierung 138 bezeichnet. Solche Lotverbindungen sind von Dickschichtschaltungen und solche Metallisierungen 137 und 138 von Kunststoffkondensatoren her bekannt.

Figur 7 zeigt im Schnitt eine Mehrschicht-Ausführung eines für die vorliegende Erfindung zu verwendenden Wandlers 103. Das dargestellte Ausführungsbeispiel besitzt übereinander drei Piezokeramikfolien 33, 33a und 33b. Mit 31 und 32 sind wiederum die beiden äußeren Kunststoff-Folien bezeichnet. Die die Piezokeramikfolien voneinander trennenden weiteren Kunststoff-Folien sind mit 31a und 31b bezeichnet. Nicht weiter dargestellt sind in Figur 7 die sinngemäß entsprechend der Figur 2 vorgesehenen Elektrodenbelegungen der Piezokeramikfolien und deren vorzusehende Anschlußleitungen. Die Wirkungsweise eines Mehrschichtenwandlers nach Figur 7 ist prinzipiell gleich derjenigen eines Wandlers nach Figur 2. Zum Beispiel kann auch ein Array entsprechend den Figuren 4 und 5 als Mehrschichtenwandler sinngemäß nach Figur 7 ausgestaltet sein.

Für die Dicke der Piezokeramikfolien 33, 33a, 33b kommen Abmessungen kleiner als etwa 0,5 mm in Frage. Die Dickenabmessungen der Kunststoff-Folien liegen im Bereich von Werten der gleichen Größenordnung bis jeweils bis zu 10 mal dicker als die verwendete Keramikfolie.

Figur 8 zeigt ein Anwendungsbeispiel eines erfindungsgemäßen Sensors 40 als Füllstandssensor in einem Tank 410. Die Laufzeit der an der Flüssigkeitsoberfläche 420 reflektierten und vom Sensor 40 wieder empfangenen Ultraschalls ist das Maß für die Füllstandshöhe.

## Patentansprüche

1. Ultraschall-Detektionssensor, insbesondere für Detektionen in Flüssigkeiten mit wenigstens einem Ultraschall-Wandler, der auf einer als backing wirkenden Platte (2) angebracht ist, mit einer Elektronikschaltung zum Betrieb des Wandlers als Ultraschall-Sender und/oder Ultraschall-Empfänger, **gekennzeichnet** dadurch,
   - daß die Platte ein für eine Dickschichtschaltung (5) zu verwendendes Substrat (2) ist,
   - daß auf dem Substrat (2) die Elektronikschaltung in an sich bekannter Weise als Dickschichtschaltung (5, 5a, 5b, 5c) mit Anschlüssen (6, 6a, 7) ausgeführt ist,
   - daß der Ultraschall-Wandler (3; 3,1; 3,2...) einen Schichtaufbau (Fig. 2, 6) hat, der aus wenigstens einer Folie aus Piezokeramik (33, 33a, 33b, 42) und wenigstens zwei Folien (31, 32, 31a, 31b) aus Kunststoff-Material mit einem spezifischem Gewicht kleiner etwa 2 besteht, wobei diese Kunststoff-Folien und Keramikfolien abwechselnd aufeinander folgen und dieses Folienpaket nach außen jeweils eine Kunststoff-Folie (31 und 32) aufweist, so daß die Abstrahl- bzw. Empfangsfläche des Wandlers (3; 3,1; 3,2...) zu einer äußeren Kunststoff-Folie (32) gehört und dieser Wandler mit der anderen äußeren Kunststoff-Folie (31) auf dem Substrat (2) befestigt ist und
   - daß der für diesen Wandler geltende Mittelwert des Produkts aus Schallgeschwindigkeit und Dichte im bzw. des Materials des Wandlers (3; 3,1; 3,2...) kleiner als der entsprechende Produktwert für das Substratmaterial (2) bemessen ist.

2. Sensor nach Anspruch 1, **gekennzeichnet** dadurch, daß der Schichtaufbau (Fig.2) des wenigstens einen Ultraschall-Wandlers (3, ...) so bemessen ist, daß der für diesen Wandler geltende Wert des Produkts aus Schallgeschwindigkeit und Dichte im bzw. des Materials des Wandlers (3, ...) gleich wenigstens angenähert dem Mittelwert der entsprechenden Produktwerte bemessen ist, die für das Substratmaterial einerseits und für das Medium, in das die Schallabstrahlung (4) zu erfolgen hat, andererseits gelten.

3. Sensor nach Anspruch 1 oder 2, **gekennzeichnet** dadurch, daß der wenigstens eine Ultraschall-Wandler (3, ...) und die Elektronikschaltung (5) auf ein und derselben Oberflächenseite des Substrats (2) angebracht sind.

4. Sensor nach Anspruch 1 oder 2, **gekennzeichnet** dadurch, daß der wenigstens eine Ultraschall-wandler (3, ...) auf der einen Oberflächenseite des Substrats (2) und wenigstens ein Anteil der Elektronikschaltung (5) auf der gegenüberliegenden Oberflächenseite des Substrats (2) angebracht ist.

5. Sensor nach einem der Ansprüche 1 bis 4, **gekennzeichnet** dadurch, daß die Elektronikschaltung die gesamte Sende- und Empfangsschaltung (5) umfaßt.

6. Sensor nach einem der Ansprüche 1 bis 5, **gekennzeichnet** dadurch, daß mehrere Ultraschall-Wandler (3; 3,1; 3,2...) als Wandler-Array (Fig. 1, 4 u. 5) auf dem Substrat (2) ausgeführt sind.

7. Sensor nach einem der Ansprüche 1 bis 6, gekennzeichnet dadurch, daß der wenigstens eine Ultraschall-Wandler (103) ein Wandler mit mehreren Piezokeramik-Folien (33, 33a, 33b) ist, die zusammen mit Kunststoff-Folien (31, 31a, 31b, 32), die abwechselnd im Abstand der Dicke der Kunststoff-Folien übereinander aufeinanderliegend angeordnet sind, wobei die Piezokeramikfolien und Kunststoff-Folien ein Folienpaket mit jeweils außenliegender Kunststoff-Folie (31, 32) bilden.

8. Sensor nach einem der Ansprüche 1 bis 7, gekennzeichnet dadurch, daß die Kunststoff-Folien (31, 31a, 31b, 32) über den äußeren Rand der Piezokeramik-Folien (33, 33a, 33b) hinausreichend sind (Fig. 3, 4, 6, 7).

9. Sensor nach einem der Ansprüche 1 bis 8, gekennzeichnet dadurch, daß die auf dem Substrat (2) befindliche Elektronikschaltung (5), der wenigstens einen Ultraschall-Wandler (3; ...) und das Substrat (2) mit einer Schutzumhüllung (41) umgeben sind, wobei jedoch die Oberfläche der gegenüber dem Substrat (2) jeweils außenliegenden Kunststoff-Folie (32) des betreffenden Wandlers für unbehinderte Ultraschallaussendung (4) bzw. -empfang von der Umhüllung freigehalten ist und die Anschlüsse (6, 6a, 7) für Zuführung der Versorgungsspannung und für den Signalausgang durch die Schutzumhüllung (41) nach außen hin durchgeführt sind.

10. Sensor nach einem der Ansprüche 1 bis 9, gekennzeichnet dadurch, daß die Kontaktierung der Piezokeramik-Folien (33, 33a, 33b) durch Metallisierung der jeweiligen anliegenden Kunststoff-Folie (31, 32, 31a, 31b) bewirkt ist.

11. Sensor nach einem der Ansprüche 1 bis 10, gekennzeichnet dadurch, daß Kontaktierungen (137, 138) auf Stirnseiten des Wandlers vorgesehen sind und diese Kontaktierungen (137, 138) mit auf der Substratoberfläche vorgesehenen Leiterbahnen (9, 10) durch Lot (109, 110) nach Art einer Dickschichtschaltung verbunden sind (Fig. 6).

12. Sensor nach einem der Ansprüche 1 bis 11, gekennzeichnet dadurch, daß für ein Array die wenigstens eine Piezokeramik-Folie (Fig. 4, 5) für wenigstens eine größere Anzahl der Wandler (3, ...) einstückig ist und zwischen den einzelnen für die Wandler bestimmten Anteilen der betreffenden Piezokeramik-Folie (133) Einkerbungen (51) zur akustischen Entkopplung eingebracht sind.

13. Sensor nach einem der Ansprüche 1 bis 12, gekennzeichnet dadurch, daß das Kunststoff-Material der Folien (31, 32, 31a, 31b) ein Material der Art eines Polymers aus im wesentlichen Kohlen- und/oder Siliziumwasserstoffen ist.

14. Anwendung eines Sensors nach einem der Ansprüche 1 bis 13 für Ultraschallaussendung in Flüssigkeit.

## Claims

1. Ultrasonic sensor expecially for detecting in liquids, having at least one ultrasonic transducer, which is mounted on a plate (2) acting as backing, having electronic circuitry for operating the transducer as ultrasonic transmitter and/or ultrasonic receiver, characterized in that the plate is a substrate (2) to be used for a thick-film circuit (5), in that the electronic circuitry is constructed on the substrate (2) in a fashion known per se as thick-film circuit (5, 5a, 5b, 5c) with terminals (6, 6a, 7), in that the ultrasonic transducer (3; 3,1; 3,2...) has a laminated structure (Figure 2, 6), which consists of at least one film of piezoceramic (33, 33a, 33b, 42) and at least two films (31, 32, 31a, 31b) of plastic material with a specific weight smaller than approximately 2, these plastic films and ceramic films following one another alternately, and this film package having respectively a plastic film (31 and 32) outside, so that the emitting surface or the receiving surface of the transducer (3; 3, 1; 3,2...) belongs to an outer plastic film (32), and this transducer is attached on the substrate (2) to the other outer plastic film (31) and in that the mean value of the product of the speed of sound and the density in or of the material of the transducer (3; 3,1; 3,2...) which holds for this transsucer is dimensioned to be smaller than the corresponding value of the product for the substrate material (2).

2. Sensor according to Claim 1, characterized in that the Laminated structure (Fig. 2) of the at least one ultrasonic transducer (3,...) is dimensioned in such a way that the value of the product of the speed of sound and the density in or of the material of the transducer (3,...) which holds for this transducer is dimensioned to be at least approximately equal to the mean value of the corresponding values of the product which hold, on the one hand, for the substrate material, and, on the other hand, for the medium into which the sound emission (4) is to take place.

3. Sensor according to Claim 1 or 2, characterized in that the at least one ultrasonic transducer (3,...) and the electornic circuitry (5) are mounted on one and the same surface side of the substrate (2).

4. Sensor according to Claim 1 or 2, characterized in that the at least one ultrasonic transducer (3,...) is mounted on one surface side of the substrate (2), and at least a portion of the electronic circuitry (5) is mounted on the opposite surface side of the substrate (2).

5. Sensor according to one of Claims 1 to 4, characterized in that, the electronic circuitry comprises the entire transmitting and receiving circuit (5).

6. Sensor according to one of Claims 1 to 5, characterized in that several ultrasonic transducers (3; 3, 1; 3,2...) are constructed on the substrate (2) as transducer array (Figure 41, 4 and 5).

7. Sensor according to one of Claims 1 to 6, characterized in that the at least one ultrasonic transducer (103) is a transducer with several piezoceramic films (33, 33a, 33b), which together with plastic films (31, 31a, 31b, 32) are arranged above one another lying on one another alternating at the spacing of the thickness of the plastic films, the piezoceramic films and plastic forming a film package with plastic film (31, 32) lying outside, in each case.

8. Sensor according to one of Claims 1 to 7, characterized in that the plastic films (31, 31a, 31b, 32) reach beyond the outer edge of the piezoceramic films (33, 33a, 33b) (Figure 3, 4, 6, 7).

9. Sensor according to one of Claims 1 to 8, characterized in that the electronic circuitry (5) located on the substrate (2), the at least one ultrasonic transducer (3;...), and the substrate (2) are surrounded by a protective covering (41), it being the case, however, that the surface of the plastic film (32) of the appropriate transducer, said film lying outside in each case with respect to the substrate (2), is kept free from the covering for unrestricted ultrasonic emission (4) or ultrasonic reception, and that the terminals (6, 6a, 7) for feeding the supply voltage and for the signal output are led outside through the protective covering (41).

10. Sensor according to one of Claims 1 to 9, characterized in that the contacting of the piezoceramic films (33, 33a, 33b) is effected by metallising the particular adjacent plastic film (31, 32, 31a, 31b).

11. Sensor according to one of Claims 1 to 10, characterized in that contacts (137, 138) are provided on the end faces of the transducer, and these contacts (137, 138) are connected by solder (109, 110) in the manner of a thickfilm circuit to conductor tracks (9, 10) provided on the substrate surface (Figure 6).

12. Sensor according to one of Claims 1 to 11, characterized in that for an array, the at least one piezoceramic film (Figure 4, 5) is of one piece for at least a larger number of transducers (3,...) and nicks (51) for acoustic decoupling are introduced between the individual portions of the appropriate piezoceramic film (133) which are intended for the transducers.

13. Sensor according to one of Claims 1 to 12, characterized in that the plastic material of the films (31, 32, 31a, 31b) is a material of the type of a polymer consisting essentially of hydrocarbons and/or silanes.

14. Application of a sensor according to one of Claims 1 to 13 for ultrasonic emission in liquid.

## Revendications

1. Capteur à ultrasons, en particulier pour la détection dans des liquides avec au moins un transducteur ultrasonore qui est monté sur une plaque agissant comme appui, avec un circuit électronique pour le fonctionnement du transducteur comme émetteur d'ultrasons et/ou comme récepteur d'ultrasons, caractérisé par le fait,

– que la plaque est un substrat (2) à utiliser pour un circuit en couche épaisse (5),

– que sur le substrat (2), le circuit électronique est réalisé de manière connue sous la forme d'un circuit en couche épaisse (5, 5a, 5b, 5c) avec des bornes de raccordement (6, 6a, 7),

– que le transducteur ultrasonore (3; 3, 1; 2...) est une structure stratifiée (figures 2, 6) qui est formée par une feuille en un matériau piézo-céramique (33, 33a, 33b, 43) et par au moins deux feuilles (31, 32, 31a, 31b) en une matière plastique, à poids spécifique inférieur à 2, lesdites feuilles en matière plastique et lesdites feuilles en céramique étant alternées et ce paquet de feuilles présentant vers l'extérieur respectivement une feuille de matière plastique (31 et 32), en sorte que la surface émettrice, respectivement la surface de réception du transducteur (3; 3, 1; 3, 2...) appartient à une feuille de matière plastique extérieure (32) et que ce transducteur est fixé par l'autre feuille de matière plastique extérieure (31) sur le substrat (2), et

– que la valeur moyenne, valable pour ce transducteur, du produit formé par la vitesse du son et par la densité dans ou du matériau du transducteur (3; 3, 1; 3, 2...) est inférieure à la valeur correspondante du produit pour le matériau du substrat (2).

2. Capteur selon la revendication 1, caractérisé par le fait que la structure stratifiée (figure 2) d'au moins l'un (3,...) des transducteurs ultrasonores est dimensionnée de telle façon que la valeur du produit de la vitesse du son et de la densité dans ou du matériau du transducteur (3,...), et qui est valable pour ce dernier, est dimensionnée pour être au moins sensiblement égale à la valeur moyenne des valeurs correspondantes du produit, qui sont valables pour le matériel du substrat, d'une part et, pour le milieu d'autre part, dans lequel l'émission du rayonnement (4) doit avoir lieu.

3. Capteur selon la revendication 1 ou 2, caractérisé par le fait qu'au moins le transducteur ultrasonore (3,...) et le circuit électronique (5) sont montés sur une seule et même surface du substrat (2).

4. Capteur selon la revendication 1 ou 2, caractérisé par le fait qu'au moins l'un (3,...) des transducteurs ultrasonores est monté sur une surface du substrat (2) et au moins une partie du circuit électronique (5) est monté sur la surface opposée du substrat (2).

5. Capteur selon l'une des revendications 1 à 4, caractérisé par le fait que le circuit électronique comprend la totalité du circuit émetteur et récepteur (5).

6. Capteur selon l'une des revendications 1 à 5, caractérisé par le fait que plusieurs transducteurs ultrasonores (3; 3, 1; 3, 2...) sont réalisés suivant une rangée de transducteurs (figures 1, 4 et 5) sur le substrat (2).

7. Capteur selon l'une des revendications 1 à 6, caractérisé par le fait qu'au moins l'un (103) des transducteurs ultrasonores est constitué par un transducteur à plusieurs feuilles piézo-céramiques (33, 33a, 33b) qui sont disposées, avec les feuilles en matière plastique (31, 31a, 31b, 32) en alternance les unes sur les autres avec une distance qui correspond à l'épaisseur des feuilles en matière plastique, les feuilles piézo-céramiques et les feuilles en matière plastique formant un paquet de feuilles comportant sur son côté extérieur respectivement une feuille de matière plastique (31, 32).

8. Capteur selon l'une des revendications 1 à 7, caractérisé par le fait que les feuilles de matière plastique (31, 31a, 31b, 32) débordent le bord extérieur des feuilles piézo-céramiques (33, 33a, 33b) (figures 3,4, 6, 7).

9. Capteur selon l'une des revendications 1 à 8, caractérisé par le fait que le circuit électronique (5) qui se trouve sur le substrat (2), au moins l'un (3;...) des transducteurs ultrasonores et le substrat (2) sont entourés d'une enveloppe de protection (41), étant toutefois noté que la surface de la feuille de matière plastique (32) du transducteur concerné, et qui se trouve à l'extérieur par rapport au substrat (2), est dégagée de l'enveloppe en vue de l'émission (4) ou de la réception, sans gêne, des ultrasons, alors que les bornes de raccordement (6, 6a, 7) servant à amener la tension d'alimentation et à l'émission des signaux, émergent à travers l'enveloppe de protection (41).

10. Capteur selon l'une des revendications 1 à 9, caractérisé par le fait que l'établissement des contacts des feuilles piézo-céramique (33, 33a, 33b) est obtenu par métallisation des feuilles de matière plastique respectivement jointives (31, 32, 31a, 31b).

11. Capteur selon l'une des revendications 1 à 10, caractérisé par le fait que sur les côtés frontaux du transducteur sont prévus des contacts (137, 138) et que ces contacts (137, 138) sont reliés par de la soudure (109, 110) aux pistes conductrices (9, 10) qui sont prévues sur la surface du substrat, à la manière d'un circuit en couche épaisse (6).

12. Capteur selon l'une des revendications 1 à 11, caractérisé par le fait que pour une rangée, au moins une feuille piézo-céramique (figures 4, 5) pour au moins un plus grand nombre de transducteurs (3,...), est d'une pièce et qu'entre les parties de la feuille piézo-céramique correspondante (133), qui sont destinées pour des transducteurs, des encoches (51) sont ménagées en vue du découplage acoustique.

13. Capteur selon l'une des revendications 1 à 12, caractérisé par le fait que le matériau plastique des feuilles (31, 32, 31a, 31b) est un matériau du genre d'un polymère formé, pour l'essentiel, par des hydrocarbures et/ou par des hydrures de silicium.

14. Mise en œuvre d'un capteur selon l'une des revendications 1 à 13, pour l'émission d'ultrasons dans des liquides.

FIG 1

FIG 2

FIG 8

EP 0 182 140 B1

## FIG 3

## FIG 4

## FIG 5

# FIG 6

# FIG 7